(19) Europäisches Patentamt
European Patent Office
Office européen des brevets

(11) **EP 2 311 042 B1**

(12) **FASCICULE DE BREVET EUROPEEN**

(45) Date de publication et mention de la délivrance du brevet:
**21.11.2018 Bulletin 2018/47**

(21) Numéro de dépôt: **09804560.2**

(22) Date de dépôt: **04.08.2009**

(51) Int Cl.:
*G11C 19/28* *(2006.01)*    *G11C 19/18* *(2006.01)*

(86) Numéro de dépôt international:
**PCT/EP2009/060083**

(87) Numéro de publication internationale:
**WO 2010/015621 (11.02.2010 Gazette 2010/06)**

(54) **REGISTRE A DECALAGE A TRANSISTORS A EFFET DE CHAMP**

SCHIEBEREGISTER AUF BASIS VON FELDEFFEKTTRANSISTOREN

SHIFT REGISTER BASED ON FIELD-EFFECT TRANSISTORS

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **08.08.2008 FR 0804537**

(43) Date de publication de la demande:
**20.04.2011 Bulletin 2011/16**

(73) Titulaire: **Thomson Licensing**
**92130 Issy-les-Moulineaux (FR)**

(72) Inventeurs:
• **LEBRUN, Hugues**
  **F-38500 Coublevie (FR)**
• **KRETZ, Thierry**
  **F-38430 Saint Jean De Moirans (FR)**
• **HORDEQUIN, Chantal**
  **F-38113 Veurey Voroize (FR)**

(74) Mandataire: **Esselin, Sophie**
**Marks & Clerk France**
**Conseils en Propriété Industrielle**
**Immeuble Visium**
**22 avenue Aristide Briand**
**94117 Arcueil Cedex (FR)**

(56) Documents cités:
**WO-A-2007/013010      WO-A1-2009/030776**
**JP-A- 2006 228 312      US-A- 5 701 136**
**US-A1- 2005 008 114      US-A1- 2007 274 433**

## Description

La présente invention concerne un registre à décalage à transistors à effet de champ optimisé, particulièrement adapté pour commander les lignes de sélection d'une matrice active d'un écran plat tel qu'un écran à cristal liquide ou OLED (*Organic light-emitting diode*).

Dans un écran plat à matrice active, chaque point image est adressé au moyen d'un transistor de commutation. Chaque ligne de sélection de la matrice est ainsi connectée aux grilles des transistors de commutation d'une rangée de points image. Ces lignes sont donc fortement capacitives. A chaque trame vidéo, elles sont chacune sélectionnées en séquence, une à une suivant un sens de balayage des lignes de l'écran, pendant un temps de sélection de ligne correspondant à une fraction de la durée de la trame, permettant l'application sur les points image de la rangée, des tensions vidéo.

La sélection d'une ligne correspond ainsi à l'application pendant le temps de sélection de ligne correspondant, d'un niveau de tension déterminé qui commande l'état passant des transistors de commutation de la rangée de points image correspondante. En dehors du temps de sélection de la ligne, celle-ci est maintenue à un niveau de tension apte à maintenir à l'état bloqué les transistors de commutation de la matrice active. On note habituellement Vgon et Vgoff les niveaux de tension à appliquer sur la ligne pour rendre passant (Vgon) et bloquer (Vgoff) ces transistors. Ces niveaux sont déterminés en fonction des tensions vidéo caractéristiques.

La commande des lignes de sélection est habituellement assurée par des circuits qui comprennent un ou plusieurs registres à décalage en série, comportant chacun une pluralité d'étages en cascade, chaque étage étant apte à commuter les niveaux Vgon et Vgoff en sortie sur une ligne correspondante de la matrice, selon le séquencement de la sélection des lignes.

Il est bien connu dans le domaine des écrans plats d'utiliser des transistors à effet de champ, en couches minces (TFT), tant pour les transistors de commutation dans la matrice active, qui permettent l'application d'une tension sur un pixel, que pour les transistors des registres à décalage des circuits de commande des lignes de sélection de cette matrice. Les demandes de brevet US 2005/008114, WO 2007/013010, US 5 701 136 concernent de tels registres à décalage à transistors silicium amorphe.

Un problème bien connu rencontré par les concepteurs de tels circuits, est la gestion de la dérive de la tension de seuil des transistors en couches minces. Cette dérive dépend notamment des conditions de température, mais aussi des niveaux de tension appliqués et du niveau de courant conduit par ces transistors. Elle conditionne leur durée de vie.

Par ailleurs, l'intégration sur le même substrat, de la matrice active et des circuits de commande est intéressante. Mais elle suppose que les circuits de commande prennent peu de place, surtout lorsque le nombre de pixels de la matrice est élevé.

Des circuits de commande des lignes ont été conçus pour répondre à ces différents besoins. En particulier on connaît de la demande de brevet EP 0815 562, une structure de registre à décalage à transistors à effet de champ, de même polarité, en faible nombre, peu encombrant. Cette structure conduit à un faible rapport cyclique des transistors, et est aussi conçue pour limiter les niveaux de tension qui leur sont appliqués. En particulier, lorsqu'un étage n'est pas actif, ses transistors ont leur tension grille-source inférieure ou égale à zéro. Ces conditions de commande des transistors permettent d'améliorer leur durée de vie.

Plus précisément, cette structure est basée sur l'utilisation dans chaque étage d'un transistor de sortie apte à conduire un courant suffisant pour charger la ligne capacitive en sortie, associé à une capacité d'élévation, appelée encore capacité de "bootstrap", connectée entre sa grille et sa source. Le drain du transistor de sortie reçoit un signal d'horloge ; sa source forme le noeud de sortie sur une ligne de la matrice active ; sa grille est commandée par le biais d'un transistor de précharge, qui amène la grille à un potentiel de précharge permettant de commander l'état passant du transistor de sortie à l'entrée dans la phase de sélection de ligne. Dans la phase de sélection, la grille du transistor de sortie suit alors le potentiel de sa source via la capacité d'élévation, ce qui maintient le transistor à l'état passant pendant toute la phase de sélection de ligne. Le potentiel de précharge de grille est déterminé pour que le transistor de sortie conduise un courant de sortie de niveau suffisant pour transférer une impulsion du signal d'horloge appliqué sur son drain, vers sa source qui forme le noeud de sortie. La grille du transistor de sortie est aussi commandée par un transistor de décharge activé après la phase de sélection de ligne, pour amener la grille du transistor de sortie à un niveau de tension permettant son blocage.

Si cette structure est intéressante en ce qu'elle ne nécessite qu'un faible nombre de transistors, commandés avec un faible rapport cyclique et des faibles niveaux de tension, optimisés compte tenu des niveaux Vgon et Vgoff à appliquer en sortie, elle présente cependant une sensibilité à la dérive de la tension de seuil du transistor de sortie, qui limite sa durée de vie.

En effet, on a vu que dans la phase de sélection, le potentiel de grille augmente avec le potentiel de source, par l'effet d'élévation par la capacité connectée entre grille et source. Si on note V1 le potentiel de précharge de la grille à l'entrée dans la phase de sélection, le potentiel de grille augmente ensuite d'une quantité Va proportionnelle à la tension au noeud de sortie Vgon. La tension grille-source Vgs vue par les transistors de sortie pendant chaque phase de sélection de ligne est ainsi supérieure à la tension de seuil du transistor. Elle induit au cours du temps une dérive de la tension de seuil, qui peut atteindre une dizaine de volts. Du fait de la dérive, il arrive un moment où le niveau de tension V1 préchargé sur la grille n'est plus suffisant pour rendre un transistor de sortie passant, ou du moins suffisamment conducteur pour charger la capacité du noeud de sortie ou de la ligne. Ce moment marque la fin de vie du registre à décalage.

Aussi, selon la durée de vie du circuit de commande désirée, en cohérence avec la durée de vie de la matrice active avec lequel on doit l'intégrer, on est amené à définir un niveau de tension de précharge V1 supérieur au niveau de tension de précharge qui serait nécessaire, et suffisant, en début de vie du transistor de sortie pour simplement charger la capacité de la ligne.

En pratique, le niveau de tension de précharge V1 appliqué par le transistor de précharge est égal au niveau Vgon fourni par le noeud de sortie de l'étage précédent, pendant le temps de sélection de ligne associé, moins la tension de seuil du transistor de précharge. Ainsi, c'est le niveau Vgon que l'on est amené à surévaluer, en fonction de la durée de vie recherchée, pour tenir compte de la dérive dans le temps de la tension de seuil des transistors de sortie.

Par exemple, un transistor dont la tension de seuil en début de vie est de l'ordre de 1 à 2 volts, peut voir sa tension de seuil dériver d'environ 13 volts. On pourra choisir dans ce cas une tension Vgon de l'ordre de 20 volts, alors qu'en début de vie, une tension Vgon de l'ordre de 7 volts aurait été suffisante. Ce faisant, en début de vie, le transistor de sortie est alors extrêmement conducteur. Le courant excessif en sortie tend à accélérer la vitesse avec laquelle la tension de seuil du transistor de sortie va dériver. Sa durée de vie s'en trouve diminuée.

Pour chaque application ou produit visé, la conception d'un tel registre doit ainsi tenir compte de trois critères :

- le niveau de courant minimum que le transistor de commande doit être capable de fournir pour charger la ligne en sortie. Cela va dépendre notamment du type d'écran concerné, en particulier du nombre de points image par ligne et de la technologie utilisée. Ce niveau de courant minimum définit la fin de vie du transistor : Partant du démarrage, la première fois, du produit (i.e. l'écran), la fin de vie est marquée par le moment où le transistor de sortie ne sera plus capable de fournir ce courant minimum.
- la vitesse de dérive de la tension de seuil du transistor de sortie, qui est une fonction du niveau de tension appliqué sur sa grille, et de sa technologie.
- le niveau maximum Vgon que l'on peut appliquer au circuit de commande, ce qui est fonction du contrôleur d'écran concerné.

L'invention a pour objet d'améliorer la durée de vie des registres à décalage.

Une idée à la base de l'invention est d'améliorer la commande de leurs transistors de sortie, en adaptant le niveau de tension de précharge de leur grille, à leur niveau de conduction, c'est-à-dire à leur tension de seuil, en sorte qu'il soit moins élevé en début de vie, qu'en fin de vie. Par suite dans la phase de sélection de ligne, la tension grille source du transistor de sortie sera plus faible en début de vie qu'en fin de vie, et adaptée au bon niveau de conduction du transistor de sortie.

La solution technique apportée par l'invention réside dans l'utilisation pour chaque transistor de sortie, d'un transistor de même technologie, réalisé en même temps que lui, et dont la tension de seuil va dériver au cours du temps au moins aussi vite que la sienne, pour adapter le niveau de la tension de précharge à sa tension de seuil.

Telle que revendiquée par les revendications indépendantes 1 et 2, l'invention concerne donc un registre à décalage réalisé avec des transistors à effet de champ de même polarité comportant une pluralité d'étages identiques en cascade, un signal d'horloge et un signal d'horloge complémentaire étant appliqués respectivement comme premier et deuxième signal d'horloge dans les étages pairs et comme deuxième et premier signal d'horloge dans les étages de rang impair, et les étages étant séquencés pour transmettre l'un après l'autre, une impulsion d'horloge sur un noeud de sortie, pendant une phase de sélection de ligne correspondante, chaque étage comprenant :

- un transistor de sortie dont la grille est connectée à un noeud interne, dont la source forme le noeud de sortie de l'étage, et dont le drain reçoit le premier signal d'horloge de l'étage, et comportant une capacité connectée entre sa grille et sa source,
- un premier transistor de commande connecté au dit noeud interne, apte à amener ledit noeud interne à une tension de précharge pendant une phase de précharge précédent ladite phase de sélection de ligne, telle que le transistor de sortie est passant pendant la phase de sélection de ligne,
- un deuxième transistor de commande connecté au dit noeud interne, apte à amener ledit noeud interne à une tension de blocage du transistor de sortie, dans une phase de désélection de ligne suivant ladite phase de sélection de ligne, et
- une capacité C1 connectée au dit noeud interne ($P_n$) et commandée par le deuxième signal d'horloge complémentaire du premier signal d'horloge appliqué sur le drain d3 du transistor de sortie,

caractérisé en ce que chaque étage comprend un transistor supplémentaire de même technologie et de même polarité que ledit transistor de sortie, dont le drain (d5) est connecté au dit noeud interne ($P_n$), et la source est polarisée à une tension de blocage du transistor de sortie au moins pendant ladite phase de précharge, et dont la fonction est d'ajuster la tension au dit noeud interne en fonction des performances de conduction dudit transistor de sortie pendant ladite phase de précharge et/ou de sélection de l'étage. Le transistor supplémentaire est monté en diode, grille et drain reliés, ou bien sa grille est reliée à la grille du premier transistor.

L'optimisation de la tension de précharge au niveau de conduction du transistor de sortie obtenu vaut pour la durée d'utilisation du début à la fin de vie : au fur et à mesure de l'utilisation du circuit, le transistor supplémentaire devient de moins en moins actif à limiter la tension de précharge. On montrera que cette optimisation vaut aussi pour la température d'utilisation.

L'invention s'applique à un écran plat à matrice active. Elle permet en particulier l'intégration sur un même substrat, et avec la même technologie de transistors, de la matrice et du circuit de commande des lignes de sélection.

D'autres avantages et caractéristiques de l'invention sont détaillés dans la description suivante en référence aux dessins illustrés d'un mode de réalisation de l'invention, donné à titre d'exemple non limitatif. Dans ces dessins :

- la figure 1, est un schéma général d'un registre à décalage de commande de lignes d'une matrice active;
- la figure 2a détaille une structure d'un étage d'un registre à décalage selon l'état de l'art, auquel peut s'appliquer l'invention ;
- la figure 2b est un chronogramme des signaux illustrant le fonctionnement d'un tel registre ;
- la figure 3 illustre un premier mode de réalisation d'un étage d'un tel registre à décalage selon l'invention;
- la figure 4 montre les différentes courbes de la tension au noeud de grille du transistor de sortie d'un étage en début de vie et en fin de vie, selon l'état de l'art et selon l'invention;
- la figure 5 illustre un deuxième mode de réalisation de l'invention;
- la figure 6 illustre une variante de ce mode de réalisation;
- la figure 7 illustre un troisième mode de réalisation de l'invention;
- la figure 8 illustre une variante de commande applicable aux différents modes de réalisation de l'invention illustrés aux figures 3, 5 et 6 ; et
- la figure 9 illustre schématiquement un substrat de matrice active à circuits de commande intégrés.

L'invention s'applique de manière générale aux registres à décalage réalisés avec des transistors à effet de champ de même polarité. Elle est plus particulièrement décrite, sans y être limitée, dans le cadre de registres utilisant des transistors en couches minces TFT, par exemple à silicium amorphe, pour lesquelles elle est particulièrement avantageuse pour la commande des lignes de sélection de matrice active d'un écran plat.

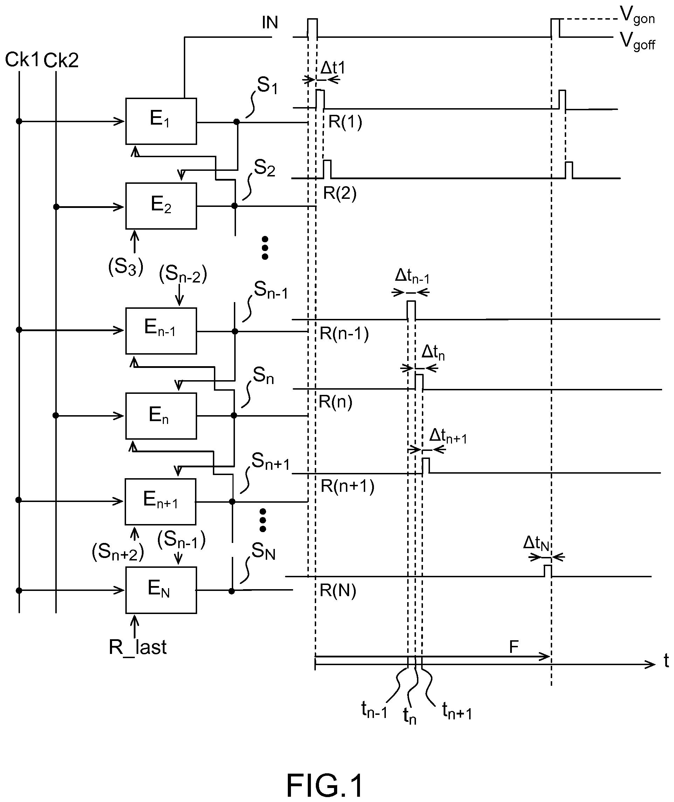

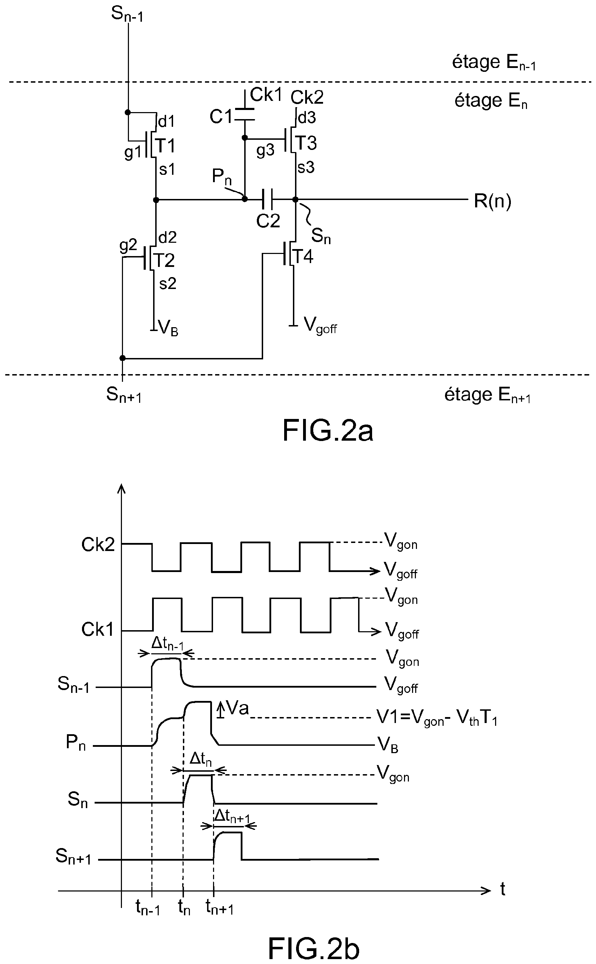

Un registre à décalage comprend de manière bien connue, comme illustré à la figure 1, N étages identiques $E_1$ à $E_N$ en cascade. Les étages de rang pair $E_1$, $E_{n-1}$, $E_{n+1}$, ...$E_N$, reçoivent un signal d'horloge Ck1. Les étages de rang impair $E_2$, $E_n$, reçoivent un signal d'horloge complémentaire Ck2. Les niveaux haut et bas de ces signaux d'horloge sont les niveaux Vgon et Vgoff. Ils sont illustrés sur la figure 2b.

Le premier étage $E_1$ reçoit un signal de balayage ligne IN (balayage vertical), transmettant une impulsion d'horloge pour chaque nouvelle trame vidéo F à afficher. Cette impulsion du signal IN va se "propager" en sortie $S_1$ du premier étage $E_1$, puis de ligne en ligne, sur les sorties des étages $E_1$, $E_2$, .... $E_n$, ...$E_N$, en sorte que les lignes R(1) à R(N) sont sélectionnées l'une après l'autre, pendant une phase de sélection de ligne correspondante, $\Delta t_1$, $\Delta t_2$, ...$\Delta t_n$,...$\Delta t_N$, une fois par trame F.

Une structure de base d'un étage $E_n$ d'un tel registre à décalage, comme divulguée dans la demande européenne précitée, comprend (figure 2a) :

- un transistor de sortie T3 dont la grille g3 est connectée à un noeud interne $P_n$ ; dont la source s3 forme le noeud de sortie $S_n$ de l'étage ; et dont le drain d3 reçoit le signal d'horloge de l'étage, Ck2 dans l'exemple. Il comporte une capacité C2 connectée entre sa grille et sa source : c'est la capacité d'élévation ou de "bootstrap".
- un premier transistor de commande T1 connecté au noeud interne $P_n$ par sa source apte à amener ce noeud interne à une tension de précharge V1, pendant une phase (ou un temps ligne) de précharge précédent la phase de sélection de ligne ; la tension de précharge V1 est telle que le transistor de sortie est passant pendant la phase de sélection de ligne.
- un deuxième transistor de commande T2 connecté au noeud interne, apte à amener ledit noeud interne à une tension de blocage VB du transistor de sortie T3 dans une phase suivant la phase de sélection de ligne. Cette tension de blocage du transistor de sortie est définie en pratique pour maintenir un niveau de tension de grille suffisamment faible pour que le courant de fuite dans le transistor de sortie ne puisse pas la charge de la capacité de ligne. Cette tension de blocage doit ainsi typiquement être choisie inférieure ou égale à la tension de source du transistor de sortie (Vgoff) plus sa tension de seuil. On peut par exemple choisir VB égal à Vgoff.

Son niveau optimum dépend typiquement du seuil de conduction des transistors.

Les transistors T1 et T2 sont avantageusement commandés (par leur grille) le premier, T1, par le signal fourni par le noeud de sortie $S_{n-1}$ de l'étage précédent $E_{n-1}$ ou par le signal de balayage ligne IN dans le cas du transistor T1 du premier étage $E_1$ (figure 1), le deuxième, T2, par le signal fourni par le noeud de sortie $S_{n+1}$ de l'étage suivant $E_{n+1}$ ou par un signal de fin de balayage ligne R_last dans le cas du transistor T1 du dernier étage $E_N$ (figure 1). Dans l'exemple, la grille g1 et le drain d1 du transistor T1 sont connectés en commun au noeud de sortie Sn-1. Le transistor T2 a sa grille connectée au noeud de sortie $S_{n+1}$, son drain d2 au noeud interne $P_n$, et sa source à une tension de blocage notée VB.

Pour avoir un fonctionnement optimal, on prévoit en outre généralement un autre transistor T4, connecté au noeud de sortie $S_n$ et dont la source est connectée à la tension de blocage des transistors de commutation de la matrice, c'est-à-dire Vgoff. Sa grille est connectée au noeud de sortie $S_{n+1}$ de l'étage suivant R(n+1). Il a pour fonction de faciliter la décharge du noeud de sortie $S_n$, à la fin de la phase de sélection de la ligne, en le tirant à Vgoff. On notera que les tensions de blocage VB et Vgoff ne sont pas nécessairement égales et peuvent être amenées par des bus d'alimentation séparés, en particulier pour des questions d'isolation.

Dans cette structure, il est par ailleurs connu de prévoir des moyens de compensation des effets de la capacité parasite grille-drain du transistor de sortie T3 pendant les commutations du signal d'horloge appliqué sur le drain d3. Dans l'invention, on utilise pour cette fonction une capacité C1 connectée au noeud interne $P_n$ et commandée par le signal d'horloge complémentaire du signal d'horloge appliqué sur le drain d3 du transistor de sortie, soit donc Ck1 dans l'exemple.

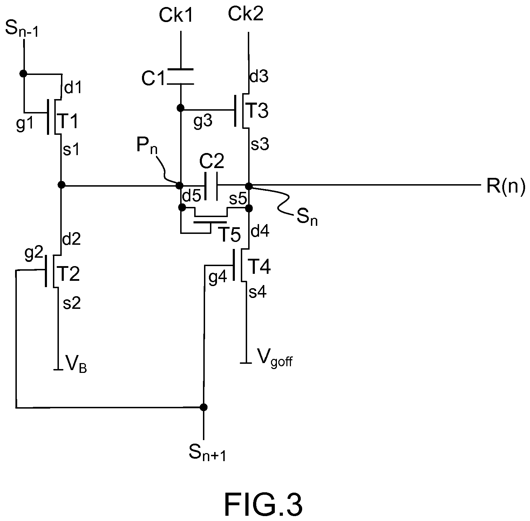

On connaît de la demande US 2005/0008114A1 publiée le 13 janvier 2005, un registre à décalage dans lequel cette fonction de compensation est assurée par un transistor (Q5, figure 3) dont la grille est commandée à haute fréquence, par la même horloge qui pilote le drain du transistor de sortie. Pour chaque trame d'affichage, ce transistor de compensation est ainsi activé 1 ligne sur deux, ce qui n'est pas sans influence sur sa durée de vie. En outre le dimensionnement de ce transistor doit être bien étudié pour ne pas avoir un effet d'écrantage de l'effet de "boostrap" sur le noeud interne $P_n$.

D'un étage au suivant, les rôles des signaux d'horloge Ck1 et Ck2 sont échangés : par exemple, dans les étages $E_{n-1}$ et $E_{n+1}$, c'est le transistor T3 qui reçoit le signal Ck1 et la capacité C1 qui reçoit le signal d'horloge Ck2 (non illustré).

Le fonctionnement d'un tel étage $E_n$ du registre va maintenant être brièvement expliqué.

La figure 2b est un chronogramme montrant les différents signaux en jeu. Les signaux d'horloge Ck1 et Ck2 sont complémentaires, ie en opposition de phase. Le niveau haut Vgon des impulsions d'horloge est défini pour que les transistors de commutation de la matrice active soient capables de charger sans perte les niveaux de tension vidéo à appliquer sur les électrodes pixel, et pour permettre la commutation à l'état passant, et suffisamment conducteur, des transistors de sortie T3 des étages du registre à décalage, en fin de vie. On a par exemple Vgon=20 volts. Le niveau bas Vgoff des impulsions est défini pour pouvoir bloquer ces transistors de commutation. On a par exemple Vgoff=-7 volts.

La phase de sélection $\Delta t_{n-1}$ de la ligne R(n-1) débute au temps $t_{n-1}$ et se termine au temps $t_n$. La phase de sélection $\Delta t_n$ de la ligne R(n) débute au temps $t_n$ et se termine au temps $t_{n+1}$, et ainsi de suite.

Pendant la phase de sélection $\Delta t_{n-1}$ de la ligne R(n-1), entre $t_{n-1}$ et $t_n$, les signaux d'horloge Ck1 et Ck2 sont respectivement à l'état haut Vgon et à l'état bas Vgoff. Le noeud de sortie $S_{n-1}$ est au niveau haut Vgon : le transistor T1 de l'étage $E_n$ est passant et charge le noeud $P_n$ de commande de la grille g3, au niveau de tension de précharge V1= Vgon-VtT1, où VtT1 est la tension de seuil du transistor T1.

Au temps $t_n$, l'état des signaux d'horloge Ck1 et Ck2 s'inverse : Ck1 passe à l'état bas Vgoff, et Ck2 passe au niveau Vgon. Le noeud de sortie $S_{n-1}$ passe à Vgoff, ce qui entraîne le blocage du transistor T1 de l'étage $E_n$.

Comme le noeud interne $P_n$ a été chargé au niveau de tension de précharge V1=Vgon-VtT1, le transistor T3 est passant. Ck2 étant à l'état haut Vgon, la source s3 suit, entraînant la grille g3 du transistor T3, qui est flottante, grâce à la capacité C2. Le transistor T3 est alors largement conducteur pendant toute la durée du temps ligne $\Delta t_n$ et le noeud de sortie $S_n$ suit parfaitement le signal d'horloge Ck2, jusqu'à sa descente au temps $t_{n+1}$. A ce moment, le noeud de sortie $S_{n+1}$ de la ligne suivante monte, rendant passant les transistors T2 et T4 de l'étage $E_n$ : le noeud interne $P_n$ et le noeud de sortie $S_n$ sont chacun tiré à une tension de blocage, respectivement VB et Vgoff. La capacité C2 est déchargée. La ligne R(n) est désélectionnée.

Lorsque Ck1 remonte à Vgon et Ck2 redescend à Vgoff, la séquence se répète pour l'étage suivant $E_{n+1}$, en remplaçant n-1 par n, n par n+1, Ck1 par Ck2 et vice versa.

La séquence de balayage des lignes de la matrice débute par l'activation du signal de commande de balayage IN, qui assure la précharge du noeud interne $P_1$ du premier étage. Le signal R_last permet de décharger le noeud interne $P_N$ et le noeud de sortie $S_N$ du dernier étage, marquant la fin de la phase de sélection de la ligne associée R(N) et la fin de la trame vidéo. Le balayage ligne recommence à la première ligne, pour la trame vidéo suivante.

Selon l'invention, on utilise dans chaque étage un transistor T5 de même technologie et de même polarité, fabriqué lors des mêmes étapes de fabrication que le transistor de sortie T3, en sorte qu'il a sensiblement la même tension de seuil en début de vie (aux écarts technologiques près) que ce transistor de sortie, pour adapter la tension de grille de ce transistor de sortie à ses performances de conduction, pendant la phase de précharge et ou de sélection de l'étage considéré.

Ainsi selon l'invention, chaque étage $E_n$ du registre à décalage comprend un transistor supplémentaire, que l'on notera T5, de même technologie, de même polarité que le transistor de sortie T3. Le drain d5 de ce transistor supplémentaire est connecté au noeud interne $P_n$, et sa source s5 est connectée à une tension de blocage du transistor de sortie T3 au moins dans la phase de précharge. La fonction de ce transistor supplémentaire est d'ajuster la tension au noeud interne $P_n$, qui est connecté à la grille du transistor de sortie T3, en fonction des performances de conduction dudit transistor de sortie T3, pendant la phase de précharge et ou de sélection de l'étage considéré.

Cette fonction peut être obtenue suivant différents modes de réalisation, en particulier avec différentes variantes de connexion de la grille et de la source de ce transistor supplémentaire. Dans tous ces modes de réalisation, les connexions du transistor T5 assurent des conditions de polarisation telles que sa tension de seuil dérive au moins aussi vite que celle du transistor de sortie, ce qui est utilisé pour adapter la tension de précharge aux conditions de conduction du transistor de sortie.

La figure 3 illustre un premier mode de réalisation. Dans ce mode de réalisation, et comme indiqué ci-dessus, le drain d5 du transistor supplémentaire T5 est connecté au noeud interne $P_n$, et la source s5 est reliée à la source s3 du transistor de sortie T3. La grille g5 du transistor T5 est reliée à la grille g3 du transistor T3 (au noeud $P_n$).

Dans ces conditions, le transistor T5 est polarisé avec la même tension grille source que le transistor de sortie T3, sur toute la durée de la trame : sa tension de seuil dérive comme celle du transistor de sortie T3.

Ainsi, adapter le niveau de tension de précharge en fonction de la tension de seuil du transistor T5 est équivalent à adapter le niveau de la tension de précharge en fonction de la tension de seuil du transistor T3 : le transistor T5 est utilisé comme une mesure de la variation de la tension de seuil du transistor de sortie T3, pour adapter le niveau de la tension de précharge. En d'autres termes, moins le transistor T3 est susceptible de conduire, moins le transistor T5 conduit et moins il décharge la grille, de manière à permettre le maintien de la conduction du transistor T3.

De manière plus détaillée, le fonctionnement va ainsi être le suivant, en se référant aux figures 2b et 3:

En début de vie, la tension de seuil des transistors T3 et T5 est à sa valeur nominale, propre à la technologie. Elle est par exemple de 1 ou 2 volts.

Pendant la phase de précharge $\Delta t_{n-1}$ de l'étage $E_n$, entre les temps $t_{n-1}$ et $t_n$, Vgon est appliqué sur le drain d1 du transistor T1 (noeud $S_{n-1}$) et Vgoff est appliqué sur la source du transistor T5 (noeud $S_n$). Le transistor T1 se met à conduire, et fait monter la tension au noeud $P_n$.

En début de vie, le transistor T5 va se mettre à conduire rapidement, dès que la tension au noeud $P_n$ dépasse sa tension de seuil. Il devient de plus en plus conducteur avec la montée du noeud $P_n$. Le courant appelé par le transistor T5 tend donc à ralentir la montée du noeud $P_n$. T1 et T5 qui conduisent en série, forment ainsi un pont diviseur au noeud $P_n$ entre Vgon et Vgoff. Ce pont diviseur limite la montée en tension du noeud $P_n$ à une valeur V1' au temps $t_n$, qui peut s'écrire :

$$V(P_n)(t_n) = V1' = (R5/(R5+R1)).(Vgon-VtT1-Vgoff)$$

où R1 et R5 sont les impédances respectives de T1 et T5.

Sans le transistor T5, la tension de précharge du noeud Pn, à l'instant $t_n$ serait : $V(P_n)(t_n) = V1 = Vgon-VtT1$.

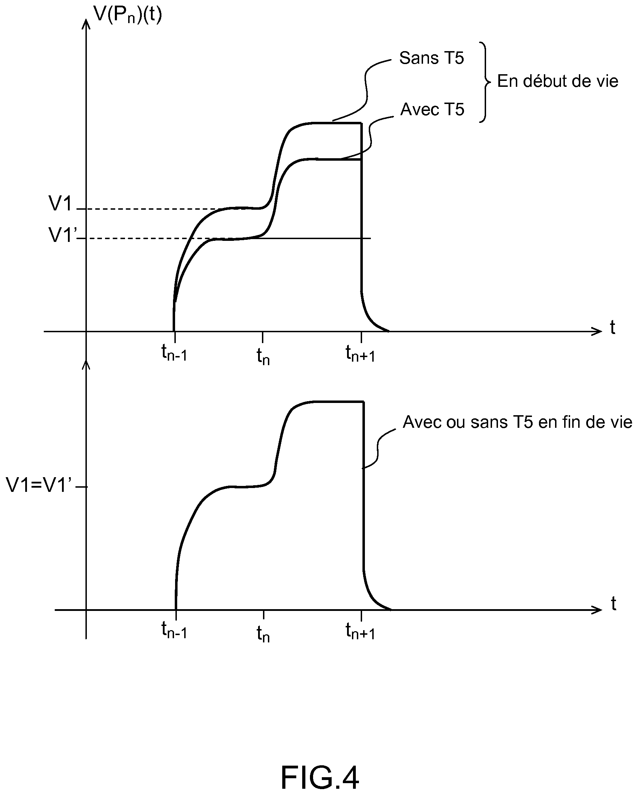

Les deux courbes de précharge $VA(P_n)(t)$ du noeud $P_n$ avec ou sans transistor T5 en début de vie sont illustrées sur la figure 4. Sans T5, le noeud $P_n$ monte à V1. Avec T5, la montée du noeud $P_n$ est limité à V1'<V1. Ce potentiel V1' est suffisant à rendre le transistor T3 passant et suffisamment conducteur, mais pas trop, pour transmettre le niveau Vgon du signal d'horloge appliqué sur son drain, vers sa source, pendant la phase suivante de sélection $\Delta t_n$ de la ligne R(n), entre $t_n$ et $t_{n+1}$. Dans cette phase de sélection, la tension au noeud $P_n$ monte avec la source s3 du transistor T3 (effet de la capacité C2), d'une quantité Va, qui est sensiblement la même dans les deux cas (avec ou sans T5).

Dans la phase de sélection entre $t_n$ et $t_{n+1}$, le transistor T5 monté en diode continue de conduire, continuant ainsi de décharger le noeud Pn et donc de limiter le stress.

En fin de vie, la tension de seuil du transistor T5 qui aura dérivée au moins autant que celle du transistor de sortie, est beaucoup plus élevée. Par exemple, elle aura dérivé de 10 volts. Pour cette raison, le transistor T5 a une impédance série élevée devant celle de T1. Cette impédance série élevée du transistor T5 a pour effet de réduire l'écart entre la tension V1' et la tension V1 que l'on aurait sans le transistor T5 de l'invention, dans la phase de précharge. En d'autres termes, en fin de vie, la courbe de précharge $V(P_N)(t)$ est sensiblement la même avec ou sans transistor T5 : V1'=V1, comme illustré sur la figure 4. Le noeud $P_n$ va pouvoir monter en tension, sans effet de limitation. Dans ces conditions, au temps $t_n$, on a $V(P_n)(t_n) = V1 = Vgon-Vgoff$.

En pratique, les dimensions du transistor T5 sont déterminées de manière à ne plus influencer la charge du

noeud interne $P_n$ en fin de vie.

Le transistor T5 selon l'invention permet d'obtenir un circuit ayant une durée de vie plus grande à Vgon constant, par rapport à un même circuit, sans le transistor T5.

Le transistor T5 permet en outre d'optimiser la commande du transistor de sortie T3 aux conditions de température.

En effet, à haute température, la mobilité des transistors est plus élevée, et la tension de seuil plus faible qu'à basse température. A haute température, la décharge du noeud interne $P_n$ sera ainsi plus efficace, la mobilité du transistor T5 étant plus grande et la tension au noeud $P_n$ en fin de précharge sera ainsi plus faible, parfaitement adaptée à la tension de seuil du transistor de sortie.

A basse température, la mobilité est réduite et la tension de seuil augmente. Le transistor T5, à mobilité réduite sera peu efficace à décharger le noeud interne $P_n$ (impédance série élevée) qui par suite atteindra un niveau de précharge au temps $t_n$ plus élevé, permettant une meilleure conduction du transistor de sortie T3.

Dans le mode de réalisation de la figure 3, les transistors T3 et T5 ont leurs grilles reliées ensemble et leurs sources reliées ensemble : ils voient ainsi la même tension grille source, quelle que soit la phase considérée. La dérive de ces tensions de seuil sont sensiblement identiques (aux dispersions technologiques près).

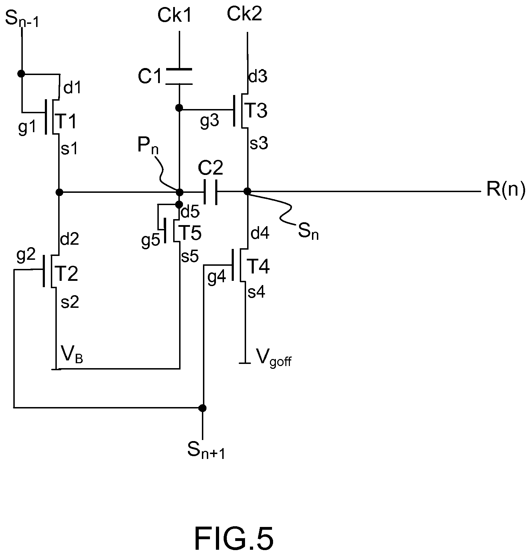

Dans un deuxième mode de réalisation de l'invention illustré à la figure 5, le transistor T5 a sa source s5 non pas connectée à la source s3 du transistor de sortie, mais à une tension constante, de blocage du transistor de sortie. Dans l'exemple illustré sur la figure 5, la source s5 est ainsi connectée à la source s2 du transistor T2. Dans une variante, la source s5 peut être polarisée à une tension de blocage correspondant au niveau bas Vgoff de tension des signaux d'horloge, typiquement en connectant la source s5 à la source s4 du transistor T4.

Dans ce mode de réalisation, les transistors T3 et T5 ont toujours leurs grilles g3 et g5 connectées ensemble, au même potentiel ; mais la source du transistor T5 est polarisée en permanence à une tension de blocage VB, inférieure ou égale à Vgoff, qui est le niveau bas du signal d'horloge, alors que la source du transistor T3 est polarisée à Vgon pendant le temps de sélection de la ligne $\Delta t_n$ et Vgoff le reste du temps. La tension grille-source vue par le transistor T5 est ainsi globalement plus élevée sur le temps trame. Sa tension de seuil va donc dériver plus vite que celle du transistor T3. Ceci permet d'adapter la conduction du transistor T5 en fonction de la dérive de la tension de seuil de T3. Cette variante de réalisation permet de rendre plus simple le dimensionnement du transistor T5 par rapport aux autres transistors du circuit, parce qu'il ne provoque pas de modification de la polarité de la ligne dans la phase de précharge (pas de précharge de la ligne par le chemin de conduction T1 - T5) et également parce que sa tension de seuil dérivera plus vite.

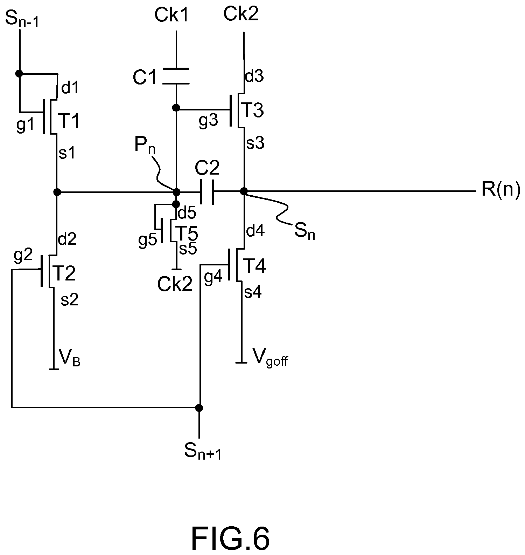

Dans un autre mode de réalisation illustré à la figure 6, le transistor T5 a sa source s5 connectée au drain d3 du transistor de sortie, c'est-à-dire, au signal d'horloge Ck2 qui pilote ce drain. Dans la phase de précharge, entre $t_{n-1}$ et $t_n$, sa source s5 est ainsi maintenue au niveau bas Vgoff du signal d'horloge Ck2, alors que dans la phase de sélection, entre $t_n$ et $t_{n+1}$, sa source s5 est ainsi maintenue au niveau haut Vgon du signal d'horloge Ck2. Dans ces deux phases, la tension grille source du transistor T5 est sensiblement égale à celle du transistor T3. Dans les autres phases de la trame F, la source de ce transistor T5 suit le signal d'horloge. La dérive de leur tension de seuil (i.e. de T3 et T5) sera sensiblement la même.

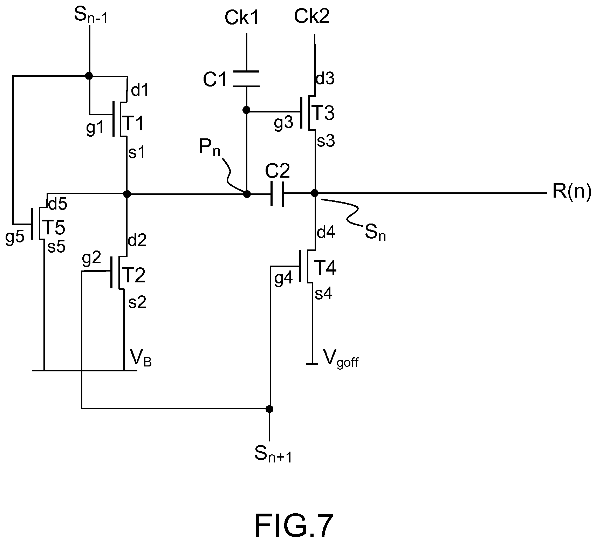

Un autre mode de réalisation est illustré sur la figure 7. Dans cette variante, la grille g5 du transistor T5 est reliée à la grille g1 du transistor T1. Dans le mode de réalisation illustré (figure 6) la source s5 du transistor T5 est reliée à la source s2 du transistor T2, à la tension de blocage VB du transistor de sortie T3. La source s5 du transistor T5 pourrait aussi être polarisée à la tension de blocage Vgoff des transistors de commutation (niveau bas des signaux d'horloge). Dans l'exemple illustré, ceci serait typiquement obtenu en connectant sa source s5 à la source s4 du transistor T4.

Dans ce mode de réalisation, le transistor T5 est activé et bloqué en même temps que le transistor T1. Il n'est donc actif que dans la phase de précharge (qui est aussi la phase de sélection de la ligne précédente), entre les temps $t_{n-1}$ et $t_n$. Ce mode de réalisation rend plus simple la détermination des tailles respectives des transistors T1 et T5, pour déterminer la tension V1'. Ces tailles respectives des transistors T1 et T5 sont choisies en fonction de la tension V1' que l'on cherche à obtenir au noeud $P_n$ à la fin de la phase de précharge, en début de vie du circuit. Le transistor T5 est de moins en moins actif au fur et à mesure du vieillissement du circuit.

Dans ce mode, le transistor T5 est polarisé à une tension grille source égale à Vgon (tension sur sa grille) moins VB, pendant le temps $\Delta t_{n-1}$, et à une tension égale à Vgoff moins VB, le reste de la trame. Le transistor T3, quand il est actif, pendant le temps $\Delta t_n$, est polarisé avec une tension grille source égale à V1'+Va (sa tension de grille) moins Vgon (sa tension de source). Cette tension est inférieure ou égale à celle du transistor T5 à l'état actif. Pour ces raisons, la tension de seuil du transistor T5 va dériver de la même façon ou plus vite que celle du transistor T3.

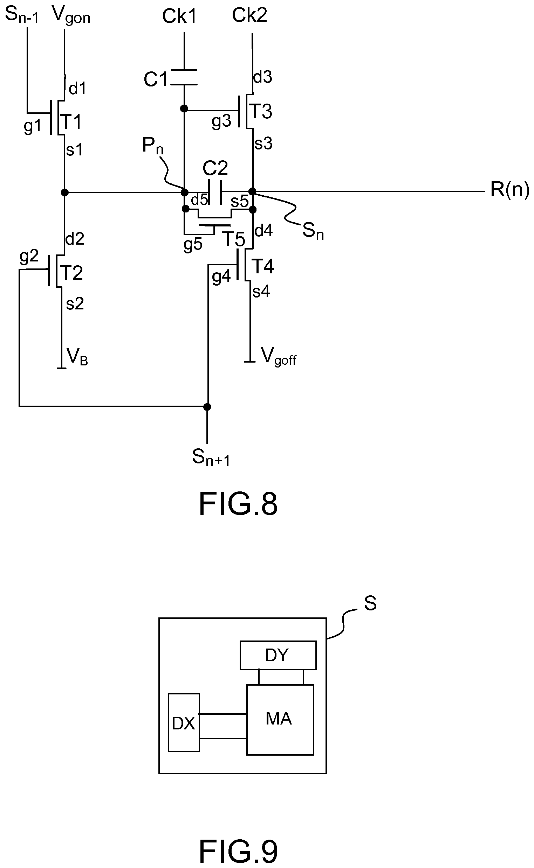

La figure 8 illustre un perfectionnement de l'invention, applicable aux différents modes de réalisation déjà décrits. Il est expliqué en reprenant le mode de réalisation illustré à la figure 3.

Dans ce perfectionnement, le drain d1 du transistor T1 n'est plus connecté à la grille de g1. Il est relié à la tension Vgon. Ce schéma électrique permet d'éviter une chute de tension sur le noeud de sortie $S_{n-1}$ de l'étage précédent

$E_{n-1}$, lorsque les transistors T1 et T5 de l'étage $E_n$ conduisent, dans la phase de précharge, c'est-à-dire lorsque le noeud $S_{n-1}$ est à Vgon.

On prévoit alors en pratique un bus d'alimentation amenant la tension Vgon sur chacun des étages du circuit de commande.

L'invention permet d'augmenter la durée de vie de l'écran, en gérant mieux la dérive de la tension de seuil des transistors à effet de champ du circuit de commande, quelle que soit la technologie considérée (couches minces, MOS...).

Elle s'applique avantageusement aux écrans plats, notamment les écrans plats à cristal liquide ou OLEDs, du type à matrice active. Elle est particulièrement intéressante lorsque les circuits de commande de lignes (et de colonnes) sont réalisés sur le même substrat que la matrice active, comme illustré schématiquement sur la figure 9 : sur un même substrat S de l'écran, sont réalisés la matrice active MA, c'est à dire les électrodes pixels et leurs dispositifs de commutation associés, et un circuit de commande des lignes DX, réalisé suivant l'invention.

## Revendications

1. Registre à décalage réalisé avec des transistors à effet de champ de même polarité, comportant une pluralité d'étages identiques en cascade, un signal d'horloge (Ck2) et un signal d'horloge complémentaire (Ck1) étant appliqués respectivement comme premier et deuxième signal d'horloge dans les étages de rang pair et comme deuxième et premier signal d'horloge dans les étages de rang impair, et les étages étant séquencés pour transmettre l'un après l'autre, une impulsion d'horloge sur un noeud de sortie, pendant une phase de sélection de ligne correspondante, chaque étage ($E_n$) comprenant :

   - un transistor de sortie (T3) dont la grille est connectée à un noeud interne ($P_n$), dont la source forme le noeud de sortie ($S_n$) de l'étage, et dont le drain reçoit le premier signal d'horloge (Ck2) de l'étage, et comportant une capacité (C2) connectée entre sa grille et sa source,
   - un premier transistor de commande (T1) connecté au dit noeud interne ($P_n$), apte à amener ledit noeud interne, à une tension de précharge dans une phase de précharge ($\Delta t_{n-1}$) précédent ladite phase de sélection de ligne($\Delta t_n$}, telle que le transistor de sortie (T3) est passant pendant ladite phase de sélection de ligne,
   - un deuxième transistor de commande (T2) connecté au dit noeud interne ($P_n$), apte à amener ledit noeud interne à une tension de blocage du transistor de sortie, dans une phase de désélection suivant ladite phase de sélection de ligne, et
   - une capacité C1 connectée au dit noeud interne ($P_n$) et commandée par le deuxième signal d'horloge complémentaire du premier signal d'horloge appliqué sur le drair (d3) du transistor de sortie,

   **caractérisé en ce que** chaque étage comprend un transistor supplémentaire (T5) de même technologie et de même polarité que ledit transistor de sortie, monté en diode, grille et drain reliés, avec le drain (d5) connecté au dit noeud interne ($P_n$), et la source polarisée à une tension de blocage du transistor de sortie au moins pendant ladite phase de précharge, et dont la fonction est d'ajuster la tension au dit noeud interne ($P_n$) en fonction des performances de conduction dudit transistor de sortie (T3) pendant ladite phase de précharge et ou de sélection dudit étage.

2. Registre à décalage réalisé avec des transistors à effet de champ de même polarité, comportant une pluralité d'étages identiques en cascade, un signal d'horloge (Ck2) et un signal d'horloge complémentaire (Ck1) étant appliqués respectivement comme premier et deuxième signal d'horloge dans les étages de rang pair et comme deuxième et premier signal d'horloge dans les étages de rang impair, et les étages étant séquencés pour transmettre l'un après l'autre, une impulsion d'horloge sur un noeud de sortie, pendant une phase de sélection de ligne correspondante, chaque étage ($E_n$) comprenant :

   - un transistor de sortie (T3) dont la grille est connectée à un noeud interne ($P_n$), dont la source forme le noeud de sortie ($S_n$) de l'étage, et dont le drain reçoit le premier signal d'horloge (Ck2) de l'étage, et comportant une capacité (C2) connectée entre sa grille et sa source,
   - un premier transistor de commande (T1) connecté au dit noeud interne ($P_n$), apte à amener ledit noeud interne, à une tension de précharge dans une phase de précharge ($\Delta t_{n-1}$) précédent ladite phase de sélection de ligne($\Delta t_n$), telle que le transistor de sortie est passant pendant ladite phase de (T3) sélection de ligne,
   - un deuxième transistor de commande (T2) connecté au dit noeud interne ($P_n$), apte à amener ledit noeud interne à une tension de blocage du transistor de sortie, dans une phase de désélection suivant ladite phase de sélection de ligne, et
   - une capacité C1 connectée au dit noeud interne ($P_n$) et commandée par le deuxième signal d'horloge complémentaire du premier signal d'horloge appliqué sur le drain (d3) du transistor de sortie,

**caractérisé en ce que** chaque étage comprend un transistor supplémentaire (T5) de même technologie et de même polarité que ledit transistor de sortie, dont la grille est reliée à la grille dudit premier transistor (T1), le drain (d5) est connecté au dit noeud interne ($P_n$), et la source est polarisée à une tension de blocage du transistor de sortie au moins pendant ladite phase de précharge, et dont la fonction est d'ajuster la tension au dit noeud interne ($P_n$) en fonction des performances de conduction dudit transistor de sortie (T3) pendant ladite phase de précharge et ou de sélection dudit étage.

3. Registre selon la revendication 1, **caractérisé en ce que** la source dudit transistor supplémentaire (T5) est connectée au drain (d3) ou à la source (s3) dudit transistor de sortie (T3).

4. Registre selon la revendication 1 ou 2, **caractérisé en ce que** la source (s5) dudit transistor supplémentaire (T5) est connectée à la source du dit deuxième transistor (T2).

5. Registre selon la revendication 1 ou 2, **caractérisé en ce que** la source (s5) dudit transistor supplémentaire (T5) est polarisée à une tension (Vgoff) correspondant au niveau bas des signaux d'horloge.

6. Registre à décalage selon l'une quelconque des revendications 1 à 5, **caractérisé en ce que** ledit premier transistor (T1) est monté en diode avec sa grille reliée à son drain, sa source (s1) étant connectée au dit noeud interne ($P_n$), sa grille (g1) recevant un signal de commande, qui est au niveau haut (Vgon) des impulsions du signal d'horloge pendant la phase de précharge, et au niveau bas sinon.

7. Registre à décalage selon l'une quelconque des revendications 1 à 5, **caractérisé en ce que** la grille (g1) dudit premier transistor reçoit un signal de commande, qui est au niveau haut (Vgon) des impulsions du signal d'horloge pendant la phase de précharge, et au niveau bas sinon, son drain (d1) recevant une tension constante, correspondant au dit niveau haut (Vgon), sa source étant connectée au noeud interne ($P_n$).

8. Ecran plat à matrice active, comprenant un registre à décalage selon l'une quelconque des revendications précédentes pour piloter les lignes de sélection de la matrice.

9. Ecran plat à matrice active selon la revendication 8, dans lequel les transistors dudit registre et les transistors de ladite matrice active sont réalisés dans la même technologie sur un même substrat.

**Patentansprüche**

1. Schieberegister mit Feldeffekttransistoren mit gleicher Polarität, umfassend eine Vielzahl identischer Kaskadenstufen, wobei ein Taktsignal (Ck2) und ein komplementäres Taktsignal (Ckl) jeweils als erstes und zweites Taktsignal in den geradzahligen Stufen und als zweites und erstes Taktsignal in den ungeradzahligen Stufen angelegt werden, wobei die Stufen getaktet sind, um nacheinander einen Taktimpuls über einen Ausgangsknoten während einer entsprechenden Leitungsauswahlphase zu übertragen, wobei jede Stufe ($E_n$) umfasst :

- einen Ausgangstransistor (T3), dessen Gate mit einem internen Knoten ($P_n$) verbunden ist, dessen Quelle den Ausgangsknoten ($S_n$) der Stufe bildet und dessen Senke das erste Taktsignal (Ck2) der Stufe empfängt, und der eine Kapazität (C2) umfasst, die zwischen Gate und Quelle verbunden ist,
- einen ersten Steuertransistor (T1), der mit dem internen Knoten ($P_n$) verbunden ist und geeignet ist, den internen Knoten auf eine solche Vorladungsspannung in einer der Leitungsauswahlphase ($\Delta t_n$) vorangehenden Vorladungsphase ($\Delta t_{n-1}$) zu bringen, dass der Ausgangstransistor (T3) während der Leitungsauswahlphase durchgeschaltet ist,
- einen zweiten Steuertransistor (T2), der mit dem internen Knoten ($P_n$) verbunden ist und geeignet ist, den internen Knoten auf eine Spannung zur Sperrung des Ausgangstransistors in einer auf die Leitungsauswahlphase folgenden Abwahlphase zu bringen und
- eine Kapazität Cl, die mit dem internen Knoten ($P_n$) verbunden ist und durch das zweite Taktsignal gesteuert wird, das komplementär zum ersten, an die Senke (d3) des Ausgangstransistors angelegten Taktsignal ist,

**dadurch gekennzeichnet, dass** jede Stufe einen zusätzlichen Transistor (T5) mit gleicher Technologie und gleicher Polarität wie der Ausgangstransistor umfasst, als Diode geschaltet ist, wobei Gate und Senke verbunden sind und die Senke (d5) mit dem internen Knoten ($P_n$) verbunden ist, und wobei die Quelle bei einer Spannung zur Sperrung des Ausgangstransistors mindestens während der Vorladungsphase polarisiert ist, und dessen Funktion darin besteht, die Spannung an dem internen Knoten ($P_n$) in Abhängigkeit von den Leitungsleistungen des Ausgangstransistors (T3) während der Phase der Vorladung oder der Auswahl der Stufe anzupassen.

2. Schieberegister mit Feldeffekttransistoren mit gleicher Polarität, umfassend eine Vielzahl identischer Kaskadenstufen, wobei ein Taktsignal (Ck2) und ein komplementäres Taktsignal (Ck1) jeweils als erstes und zweites Taktsignal in den geradzahligen Stufen und als zweites und erstes Taktsignal in den ungeradzahligen Stufen angelegt werden, wobei die Stufen getaktet sind, um nacheinander einen Taktimpuls über einen Ausgangsknoten während einer entsprechenden Leitungsauswahlphase zu übertragen, wobei jede Stufe ($E_n$) umfasst :

- einen Ausgangstransistor (T3), dessen Gate mit einem internen Knoten ($P_n$) verbunden ist, dessen Quelle den Ausgangsknoten ($S_n$) der Stufe bildet und dessen Senke das erste Taktsignal (Ck2) der Stufe empfängt, und der eine Kapazität (C2) umfasst, die zwischen Gate und Quelle verbunden ist,
- einen ersten Steuertransistor (T1), der mit dem internen Knoten ($P_n$) verbunden ist und geeignet ist, den internen Knoten auf eine solche Vorladungsspannung in einer der Leitungsauswahlphase ($\Delta t_n$) vorangehenden Vorladungsphase ($\Delta t_{n-1}$) zu bringen, dass der Ausgangstransistor (T3) während der Leitungsauswahlphase durchgeschaltet ist,
- einen zweiten Steuertransistor (T2), der mit dem internen Knoten ($P_n$) verbunden ist und geeignet ist, den internen Knoten auf eine Spannung zur Sperrung des Ausgangstransistors in einer auf die Leitungsauswahlphase folgenden Abwahlphase zu bringen und
- eine Kapazität CI, die mit dem internen Knoten ($P_n$) verbunden ist und durch das zweite Taktsignal gesteuert wird, das komplementär zum ersten, an die Senke (d3) des Ausgangstransistors angelegten Taktsignal ist,

**dadurch gekennzeichnet, dass** jede Stufe einen zusätzlichen Transistor (T5) mit gleicher Technologie und gleicher Polarität wie der Ausgangstransistor umfasst, dessen Gate mit dem Gate des ersten Transistors (T1) verbunden ist, dessen Senke (d5) mit dem internen Knoten ($P_n$) verbunden ist dessen Quelle bei einer Spannung zur Sperrung des Ausgangstransistors mindestens während der Vorladungsphase polarisiert ist, und dessen Funktion darin besteht, die Spannung an dem internen Knoten ($P_n$) in Abhängigkeit von den Leitungsleistungen des Ausgangstransistors (T3) während der Phase der Vorladung oder der Auswahl der Stufe anzupassen.

3. Register nach Anspruch 1, **dadurch gekennzeichnet, dass** die Quelle des zusätzlichen Transistors (T5) mit der Senke (d3) oder mit der Quelle (s3) des Ausgangstransistors (T3) verbunden ist.

4. Register nach Anspruch 1 oder 2, **dadurch gekennzeichnet, dass** die Quelle (s5) des zusätzlichen Transistors (T5) mit der Quelle des zweiten Transistors (T2) verbunden ist.

5. Register nach Anspruch 1 oder 2, **dadurch gekennzeichnet, dass** die Quelle (s5) des zusätzlichen Transistors (T5) bei einer Spannung (Vgoff) polarisiert ist, die dem niedrigen Pegel der Taktsignale entspricht.

6. Schieberegister nach einem beliebigen der Ansprüche 1 bis 5, **dadurch gekennzeichnet, dass** der erste Transistor (T1) als Diode geschaltet ist, wobei sein Gate mit seiner Senke verbunden ist, wobei seine Quelle (s1) mit dem internen Knoten ($P_n$) verbunden ist, wobei sein Gate (g1) ein Steuersignal empfängt, das auf dem hohen Pegel (Vgon) der Taktsignalimpulse während der Vorladungsphase und ansonsten auf dem niedrigen Pegel ist.

7. Schieberegister nach einem beliebigen der Ansprüche 1 bis 5, **dadurch gekennzeichnet, dass** das Gate (g1) des ersten Transistors ein Steuerungssignal empfängt, das auf dem hohen Pegel (Vgon) der Taktsignalimpulse während der Vorladungsphase und ansonsten auf dem niedrigen Pegel ist, wobei seine Senke (d1) eine konstante Spannung erhält, die dem hohen Pegel (Vgon) entspricht, wobei seine Quelle mit dem internen Knoten ($P_n$) verbunden ist.

8. Flachbildschirm mit aktiver Matrix mit einem Schieberegister nach einem beliebigen der vorhergehenden Ansprüche, um die Auswahlzeilen der Matrix zu steuern.

9. Flachbildschirm mit aktiver Matrix nach Anspruch 8, bei dem die Transistoren des Registers und die Transistoren der aktiven Matrix in derselben Technologie auf ein und demselben Substrat hergestellt sind.

**Claims**

1. Shift register produced using field effect transistors having a similar polarity, comprising a cascade of a plurality of identical stages, a clock signal (Ck2) and an additional clock signal (Ck1) being applied respectively as first and second clock signal in even row stages and as second and first clock signal in odd row stages, and the stages being sequenced to transmit one after the other, a clock pulse to an output node, during a corresponding line selection phase, each stage ($E_n$) comprising:

- an output transistor (T3) whose gate is connected to an internal node ($P_n$), whose source forms the output node ($S_n$) of the stage, and whose drain receives the first clock signal (Ck2) of the stage, and comprising a capacitor (C2) connected between its gate and source,
- a first driver transistor (T1) connected to said internal node ($P_n$), capable of bringing said internal node, to a precharge voltage in a precharge phase ($\Delta t_{n-1}$) preceding said line selection phase ($\Delta t_n$), such that the output transistor (T3) is passing during said line selection phase,
- a second driver transistor (T2) connected to said internal node ($P_n$), capable of bringing said internal node to a cut-off voltage of the output transistor, in a deselection phase according to said line selection phase, and
- a capacitor C1 connected to said internal node ($P_n$) and controlled by the second clock signal additional to the first clock signal applied to the drain of the output transistor,

**characterised in that** each stage comprises an additional transistor (T5) having the same technology and same polarity as said output transistor, diode-mounted, gate and drain connected, with drain (d5) connected to said internal node ($P_n$), and the source polarised to a cut-off voltage of the output transistor at least during said precharge phase, and whose role is to adjust the voltage at said internal node ($P_n$) according to the conduction performances of said output transistor (T3) during said precharge and or selection phase of said stage.

2. Shift register produced using field effect transistors having a similar polarity, comprising a cascade of a plurality of identical stages, a clock signal (Ck2) and an additional clock signal (Ck1) being applied respectively as first and second clock signal in even row stages and as second and first clock signal in odd row stages, and the stages being sequenced to transmit one after the other, a clock pulse to an output node, during a corresponding line selection phase, each stage ($E_n$) comprising:

- an output transistor (T3) whose gate is connected to an internal node ($P_n$), whose source forms the output node ($S_n$) of the stage, and whose drain receives the first clock signal (Ck2) of the stage, and comprising a capacitor (C2) connected between its gate and source,
- a first drive transistor (T1) connected to said internal node ($P_n$), capable of bringing said internal node, to a precharge voltage in a precharge phase ($\Delta t_{n-1}$) preceding said line selection phase ($\Delta t_n$), such that the output transistor conducts during said line selection phase,
- a second driver transistor (T2) connected to said internal node ($P_n$), capable of bringing said internal node to a cut-off voltage of the output transistor, in a deselection phase according to said line selection phase, and
- a capacitor C1 connected to said internal node ($P_n$) and controlled by the second clock signal additional to the first clock signal applied to the output transistor drain, **characterised in that** each stage comprises an additional transistor (T5) having the same technology and polarity as said output transistor, whose gate is connected to the gate of said first transistor (T1), the drain (d5) is connected to said internal node ($P_n$), and the source is polarised to a cut-off voltage of the output transistor at least during said precharge phase, and whose role is to adjust the voltage at said internal node ($P_n$) according to the conduction performances of said output transistor (T3) during said precharge and or selection phase of said stage.

3. Register according to claim 1, **characterised in that** the source of said additional transistor (T5) is connected to the drain (d3) or to the source (s3) of said output transistor (T3).

4. Register according to claim 1 or 2, **characterised in that** the source (s5) of said additional transistor (T5) is connected to the source of said second transistor (T2).

5. Register according to claim 1 or 2, **characterised in that** the source (s5) of said additional transistor (T5) is polarised to a voltage (Vgoff) corresponding to the low level of the clock signals.

6. Shift register according to any one of claims 1 to 5, **characterised in that** said first transistor (T1) is diode-mounted with its gate connected to its drain, its source (s1) being connected to said internal node ($P_n$), its gate (g1) receiving a control signal, which is at the high level (Vgon) of the clock signal pulses during the precharge phase, and otherwise at the low level.

7. Shift register according to any one of claims 1 to 5, **characterised in that** the gate (g1) of said first transistor receives a control signal, which is at the high level (Vgon) of the clock signal pulses during the precharge phase, and at the low level otherwise, its drain (d1) receiving a constant voltage, corresponding to said high level (Vgon), its source being connected to the internal node ($P_n$).

8. Flat screen with active matrix, comprising a shift register according to any one of the previous claims to drive the matrix selection lines.

9. Flat screen with active matrix according to claim 8, wherein the transistors of said register and the transistors of said active matrix are produced using the same technology on the same substrate.

FIG.1

FIG.2a

FIG.2b

FIG.3

FIG.4

FIG.5

FIG.6

FIG.7

FIG.8

FIG.9

## RÉFÉRENCES CITÉES DANS LA DESCRIPTION

**Documents brevets cités dans la description**

- US 2005008114 A
- WO 2007013010 A
- US 5701136 A
- EP 0815562 A
- US 20050008114 A1